# EUROPEAN PATENT SPECIFICATION

(11) **EP 3 422 414 B1**
(45) Date of publication and mention of the grant of the patent: **09.09.2020**
(21) Application number: 18180280.2
(22) Date of filing: 28.06.2018
(51) Int. Cl.: H01L 27/32, H01L 25/075, G02F 1/133

(54) **LED DISPLAY PANEL AND DISPLAY USING THE SAME**
LED-ANZEIGETAFEL UND ANZEIGE DAMIT
PANNEAU D'AFFICHAGE LED ET APPAREIL D'AFFICHAGE L'UTILISANT

(30) Priority: 29.06.2017 KR 20170082710
(43) Date of publication of application: 02.01.2019
(73) Proprietor: LG Display Co., Ltd., SEOUL, 07336 (KR)
(72) Inventor: SON, Jungeun, 10845 Gyeonggi-do (KR); SON, HyeonHo, 10845 Gyeonggi-do (KR); KIM, JinYeong, 10845 Gyeonggi-do (KR); PARK, Hanchul, 10845 Gyeonggi-do (KR); JU, Seonghwan, 10845 Gyeonggi-do (KR)
(74) Representative: Ter Meer Steinmeister & Partner

(56) References cited:
- WO-A2-2015/193868
- US-A1- 2005 116 615
- US-A1- 2015 131 321
- US-A1- 2016 141 353

## Description

### BACKGROUND

### 1. Technical Field

The present invention relates to a light emitting diode (LED) display panel which includes subminiature LEDs arranged to form pixels for displaying an image, and, more particularly, to a narrow- or zero-bezel LED display panel which allows easy arrangement of subminiature LEDs in pixel regions in manufacture thereof, and a display using the same.

### 2. Description of the Related Art

An LED is a semiconductor light emitting device configured to convert current into light and has attracted much attention in the field of image displays and high-output electronic components due to high thermal stability and broad bandgap (0.8 eV to 6.2 eV) thereof.

In order to increase resolution of a display, LEDs used in the display are required to have a further reduced size. However, as LEDs become smaller, use of the LEDs in a display is limited due to limitations in physical equipment and resolution. Accordingly, despite high efficiency, LEDs have been used in limited fields such as displays for outdoor electronic signboards or backlight units for LCDs.

Recently, high-efficiency LEDs having good physical and chemical properties have been manufactured, for example in micro scale, to be used in full-color LED displays rather than in simple backlight units.

Particularly, various attempts have been made to arrange subminiature LEDs on a TFT switching substrate for typical LCDs or OLED displays to form pixels for displaying an image.

However, in order to arrange such subminiature LEDs as image display elements in pixel regions of the TFT switching substrate for LCDs or OLED displays, it is necessary to change the layout or arrangement and/or design of the LEDs corresponding to the area of an image display region of the TFT switching substrate, pixel size, resolution and the like.

Further, it is more difficult to change the layout and design of subminiature LEDs corresponding to characteristics of a TFT switching substrate for narrow- or zero-bezel display panels, which are emerging recently. In other words, it is difficult to adjust the layout and design of the subminiature LEDs to the size of pads in a non-display region of the TFT switching substrate, the size of the substrate, the size of pixels, resolution, and the like.

Particularly, some typical TFT switching substrates for narrow- or zero-bezel display panels are designed such that pixel regions adjacent to an outer pad region are different in size than pixel regions at the center of the base substrate. Accordingly, even when the layout and design of subminiature LEDs are changed corresponding to the characteristics of a TFT switching substrate for narrow- or zero-bezel display panels, the structure or pattern of LEDs disposed in pixel regions at an outer periphery of the substrate is different from that of LEDs disposed in central pixel regions. As a result, automatic design and panel inspection is impossible, causing increase in defects.

US 2005/116615 A1 describes a display device using an organic EL element as a light emissive element, wherein a single pixel is formed of subpixels of four colors arranged in two rows and two columns. Each pixel is substantially quadrangular in shape, and at least one of the subpixels in the pixel has an area different from the areas of the other subpixels. The subpixels of the colors horizontally adjoining in the same row have the same height, and the subpixels of the colors vertically adjoining in the same column have the same width.

US 2015/131321 A1 describes a backlight assembly which includes a plurality of first light sources configured to emit a first color, and a plurality of second light sources configured to emit a second color different from the first color, where the backlight assembly is divided in a first boundary area, a second boundary area spaced apart from the first boundary area in a first direction, and a middle area between the first boundary area and the second boundary area, and an arrangement direction of first and second light sources of the plurality of first and second light sources in the first and second boundary areas is different from an arrangement direction of first and second light sources of the plurality of first and second light sources in the middle area.

WO 2015/193868 A2 describes a one way display. A plurality of light emitting elements are sandwiched between layers of a transparent material and mounted across an area of the display in groups, each group of light emitting elements making up a colored pixel of the display, and each pixel consisting of at least three adjacent or stacked red, green and blue light emitting elements so as to provide required color of the pixel by combination of the red, green and blue lights emitted from the light emitting elements, wherein the size and shape of the pixels varies in a direction away from the center of the display panel and in dependence on a distance from the center of the display panel.

US 2016/141353 A1 describes a display panel which includes a substrate, a plurality of first unit pixel and a plurality of second unit pixel. The substrate includes a first region and a second region extending in a first direction. The plurality of first unit pixels is disposed in the first region of the substrate. The first unit pixel has a first area. The plurality of second unit pixel is disposed in the second region of the substrate. The second unit pixel has a second area which is smaller than the first area.

### SUMMARY OF THE INVENTION

Embodiments of the present invention have been conceived to solve such a problem in the art and it is one aspect of the present invention to provide an LED display panel which allows easy arrangement of subminiature LEDs in pixel regions of a TFT switching substrate for LCDs or OLED displays, and a display using the same.

It is another aspect of the present invention to provide a narrow- or zero-bezel LED display panel which allows subminiature LEDs to be arranged in pixel regions without any additional design change in manufacture thereof, and a display using the same.

The objects of the present invention are solved by a display panel according to claim 1 and a display according to claim 13.

In accordance with the present invention, the pattern of the LEDs in each pixel region depends position on the base substrate, in particular it depends on from direction and distance to the center of the base substrate. So the pattern in the center of the base substrate is different from the pattern away or spaced apart from the center of the base substrate.

Particularly, when the base substrate is configured such that an area of an image display region or a size of the pixel regions is smaller than those of another base substrate, the LEDs in each pixel region are arranged in a particular pattern without changing the layout of the LEDs depending on the area of the image display region or the size of the pixel regions, such that a pixel region farther away from the center of the image display region has the LEDs arranged in the same direction as a direction away from the center of the image display region and located closer to an outer periphery thereof depending on the area of the image display region or the size of the pixel regions. So the pattern stays the same, but the position of the pattern inside the pixel region changes depending on the position of the pixel region on the base substrate.

The present invention provides an LED display panel which allows easy arrangement of subminiature LEDs in pixel regions of a TFT switching substrate for LCDs or OLED displays, thereby reducing design and production costs and improving automatic design efficiency, and a display using the same.

In addition, the present invention provides a narrow- or zero-bezel LED display panel which allows subminiature LEDs to be arranged in pixel regions without any additional design change in manufacture thereof, thereby reducing design and production costs, and a display using the same.

Further, the present invention provides an LED display panel which allows a plurality of subminiature LEDs to be arranged in each pixel region in a particular pattern in a direction away from the center of the base substrate, thereby improving ease of automatic design and panel inspection.

### BRIEF DESCRIPTION OF THE DRAWINGS

The above and other aspects, features, and advantages of the present invention will become apparent from the detailed description of the following embodiments in conjunction with the accompanying drawings, in which:
FIG. 1 is a schematic diagram of an LED display panel according to one embodiment of the present invention;
FIG. 2 is a rear view of the LED display panel of FIG. 1, which shows a back side of the LED display panel and a panel driver;
FIG. 3 is a block diagram of a pixel structure at the center of the LED display panel of FIG. 1;
FIG. 4 is a sectional view taken along line A-A' of FIG. 3;
FIG. 5 is a block diagram of a pixel structure at the outermost portion of the LED display panel of FIG. 1;
FIG. 6 is a sectional view taken along line I-I' of FIG. 5; and
FIG. 7 is a diagram illustrating data voltage contact positions of a narrow- or zero-bezel type TFT switching substrate with subminiature LEDs arranged in a particular pattern thereon.

### DETAILED DESCRIPTION

Hereinafter, embodiments of the present invention will be described with reference to the accompanying drawings. It should be understood that descriptions of details apparent to those skilled in the art will be omitted for clarity.

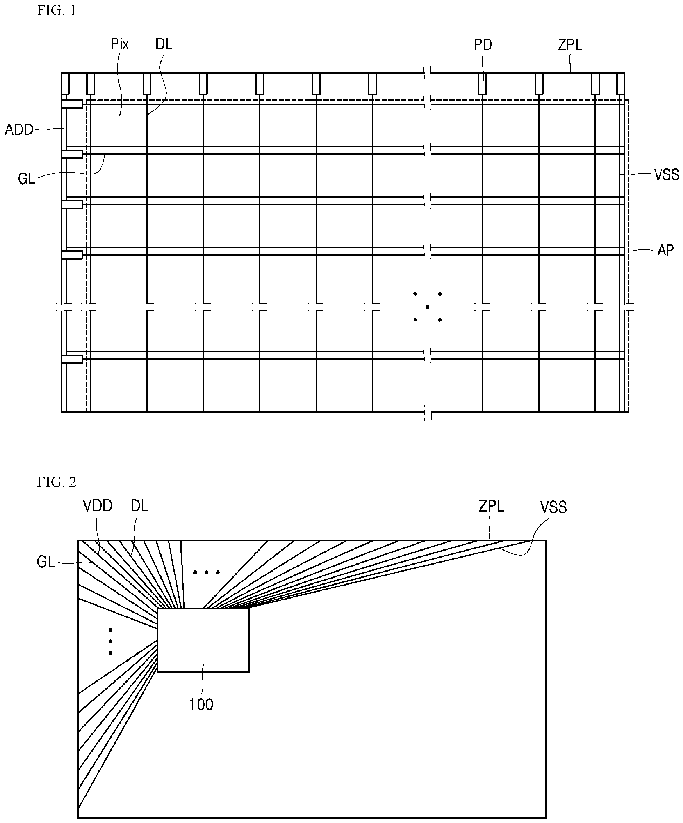

FIG. 1 is a schematic diagram of an LED display panel according to one embodiment of the present invention. FIG. 2 is a rear view of the LED display panel of FIG. 1, which shows a back side of the LED display panel and a panel driver.

Referring to FIG. 1, the LED display panel according to this embodiment of the present invention includes: a base substrate ZPL having a plurality of pixel regions Pix defined by a plurality of gate lines GL and a plurality of data lines DL and including a plurality of pads PD arranged at an outer periphery or side thereof; and a group of subminiature LEDs arranged in each of the pixel regions Pix in a particular pattern corresponding to a direction away from the center of the pixel regions and a distance of each pixel region from the center of the base substrate to display an image.

The plurality of gate lines GL are horizontally disposed and the plurality of data lines DL are vertically disposed on the base substrate ZPL to cross one another, thereby defining the plurality of pixel regions Pix. In addition, the base substrate ZPL includes a high voltage supply line VDD and a low voltage supply line VSS disposed at right and left sides thereof, respectively, wherein the high voltage supply line VDD and the low voltage supply line VSS each have a plurality of branches extending in the direction of the gate lines GL to supply high voltage and low voltage to the pixel regions. The plurality of pads PD may be formed at the outer periphery or side of the base substrate ZPL. The pads PD are connected the gate lines GL, the data lines DL, the high voltage supply line VDD, and the low voltage supply line VSS. Specifically, the plurality of pads PD may be formed along an outer periphery of a front of the base substrate ZPL, or may be formed on a back side of the base substrate ZPL.

If the plurality of pads PD is formed at least at the outer periphery or around the outer periphery of the front of the base substrate ZPL, as shown in FIG. 1, a layout on the base substrate may be designed or manufactured such that the area of an image display region AP varies depending on the size of the pads PD or the area occupied by the pads PD. For example, depending on the area of the image display region AP, the distance between adjacent gate lines GL or data lines DL may be reduced which reduces the size of the pixel regions. Alternatively, at least one of the pixel regions adjacent to the plurality of pads PD may have smaller size than the other pixel regions. AP of Fig. 1 is the image display region, and Pix of Fig. 1 is the pixel regions.

Conventionally, if the layout on the base substrate is designed such that all or some of the pixel regions are reduced depending on the size of the pads PD or the area occupied by the pads PD, as described above, the layout of the subminiature LEDs is required to be adjusted such that the distance between adjacent groups of subminiature LEDs is reduced in order to mount or integrate the group of subminiature LEDs in each pixel region.

According to the present invention, each data contact pad for applying data voltage to an anode of each of the subminiature LEDs disposed in each pixel region of the base substrate ZPL is formed in a planar shape having a specific area. In other words, each data contact pad has a planar polygonal shape having a particular area inside the pixel region instead of a contact hole or contact line-shape. Accordingly, even when the layout on the base substrate is designed such that the area of the image display region of the base substrate ZPL or the size of the pixel regions is varied, the subminiature LEDs can be arranged in each pixel region without changing layout of the subminiature LEDs, and the subminiature LEDs have a particular pattern.

Since each data contact pad has a planar shape having a specific area to be widened in contact area, the subminiature LEDs can be electrically connected to the data contact pads, respectively, even when the subminiature LEDs are arranged in the particular pattern in each pixel region without changing the layout.

Particularly, since the base substrate ZPL is configured such that the area of the image display region or the size of the pixel regions is reduced without changing the layout of the subminiature LEDs, the subminiature LEDs in each pixel region may be arranged at constant intervals in a direction away from the center of the pixel regions.

According to the present invention, when the base substrate is configured such that the overall size or area of the pixel regions is reduced due to the plurality of pads PD in the outer periphery of the substrate, as shown in FIG. 1, the subminiature LEDs in each pixel region are arranged in a particular pattern with respect to the center of the base substrate without changing layout of the subminiature LEDs, such that a pixel region farther away from the center of the image display region or base substrate has the subminiature LEDs arranged in the same pattern and direction as a pixel region close to the center of the image display region or base substrate.

Here, the particular pattern is an arrangement pattern of subminiature LEDs in which all subminiature LEDs of that group forming the pattern are arranged at particular constant intervals. Accordingly, in a pixel region farther away from the center of the image display region, each subminiature LEDs or the pattern of subminiature LEDs is disposed closer to an outer periphery of the pixel region. So, for a pixel region in or close to the center of the image display region or base substrate the pattern of subminiature LEDs of a pixel region is located in or close to the center of the pixel region. In a pixel region away from center of the image display region or base substrate or which is closer to the outer periphery of the base substrate, the pattern of subminiature LEDs of a pixel region is located outside the center of the pixel region or closer to the outer periphery of the pixel region.

Here, the distance of each pixel region from the center of the image display region may vary depending on the area of the image display region or the size of the corresponding pixel region. Accordingly, the location of the pattern of the subminiature LEDs in one pixel region is different from the location of the pattern of the subminiature LEDs in another pixel region. However, the distance between the groups of subminiature LEDs in adjacent pixel regions may be constant according to the particular pattern. Now, a pixel structure and data contact pad structure of the base substrate ZPL according to the present invention will be described in detail with reference to the accompanying drawings.

Referring to FIG. 2, a driving circuit 100 or accessory circuit elements may be disposed on a back of the LED display panel, that is, on a back of the base substrate ZPL.

The driving circuit 100 is disposed on the back of the base substrate ZPL to apply high voltage and low voltage to the plurality of pixel regions via the high voltage supply line VDD and the low voltage supply line VSS, respectively. In addition, the driving circuit 100 drives the plurality of gate lines GL on a horizontal line basis and the plurality of data lines DL on a frame basis such that an image can be displayed by the subminiature LEDs in the pixel regions.

The driving circuit 100 generates gate signals for sequentially driving the plurality of gate lines GL and sequentially generates and outputs gate-on voltage (for example, low- or high-level gate voltage) using the gate signals. In addition, the driving circuit 100 converts digital image data input from the outside or stored in the driving circuit into analog voltage, i.e., analog data voltage, and outputs the analog voltage to the data lines DL at the timing of outputting the gate-on voltage.

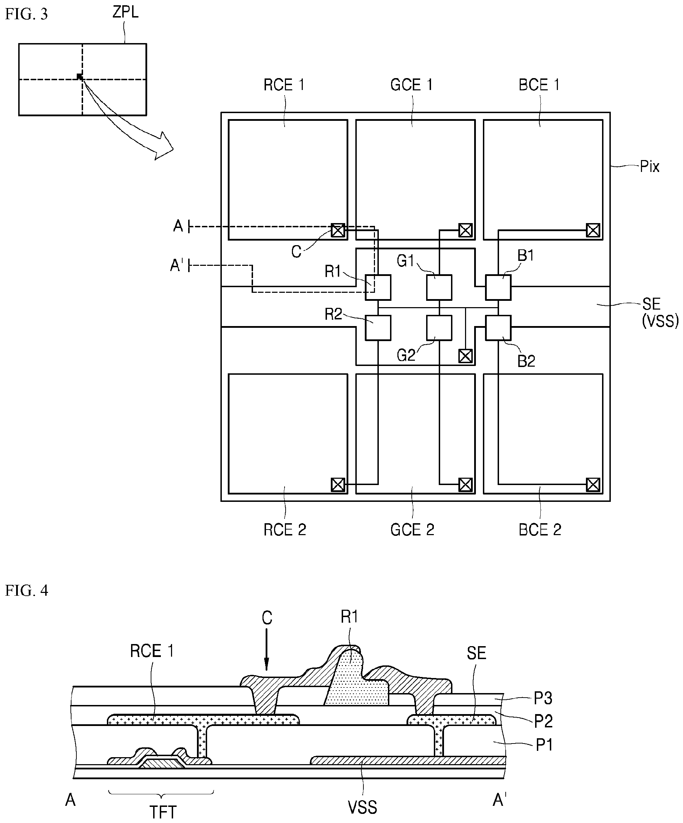

FIG. 3 is a block diagram of a pixel structure at the center of the LED display panel of FIG. 1 and FIG. 4 is a sectional view taken along line A-A' of FIG. 3.

Referring to FIGS. 3 and 4, each of pixel regions Pix includes: a plurality of TFTs switching a data voltage in response to a gate-on voltage; a low voltage contact pad SE to which a low voltage is applied; a plurality of data contact pads RCE1, GCE1, BCE1, RCE2, GCE2, BCE2 being in one-to-one correspondence with the plurality of TFTs to transmit the data voltage from the TFTs on a front surface thereof; and at least one red LED R1, R2, at least one green LED G1, G2, and at least one blue LED B1, B2 each emitting light upon receiving the low voltage from the low voltage contact pad SE at a cathode thereof and upon receiving the data voltage from a corresponding one of the plurality of data contact pads RCE1, GCE1, BCE1, RCE2, GCE2, BCE2 at an anode thereof.

For example, each pixel region Pix may include one red subminiature LED R1, one green subminiature LED G1, and one blue subminiature LED B1. Here, each pixel region may include three TFTs corresponding to the red, green, blue subminiature LEDs R1, G1, B1, three data contact pads RCE1, GCE1, BCE1 transmitting the data voltage from the TFTs to the subminiature LEDs, and one low voltage contact pad SE.

The TFTs in each pixel region are turned on upon receiving the gate-on voltage from one gate line GL. Then, the TFTs transmit the data voltage from different data lines DL to the data contact pads RCE1, GCE1, BCE1, respectively.

Each of the red, green, and blue subminiature LEDs R1, G1, B1 receives the low voltage from the low voltage contact pad SE at the cathode thereof and receives the data voltage from a corresponding one of the data contact pads RCE1, GCE1, BCE1 at the anode thereof to emit light at a brightness corresponding to the data voltage. Here, the cathode of each of the subminiature LEDs R1, G1, B1 is electrically connected to the low voltage contact pad SE via a common cathode link line. In addition, the anode of each of the subminiature LEDs R1, G1, B1 is electrically connected to the corresponding one of the data contact pads RCE1, GCE1, BCE1 via an anode link line.

In FIG. 3, each pixel region is shown as including: six TFTs; one low voltage contact pad SE; six data contact pads RCE1, GCE1, BCE1, RCE2, GCE2, BCE2; and two red subminiature LEDs R1, R2, two green subminiature LEDs G1, G2, and two blue subminiature LEDs B1, B2. However, it should be understood that the present invention is not limited thereto and the number, configuration, and layout of the aforementioned components may be varied. For example, each pixel region may include one red LED R1, one green LED G1, and one blue LED B1. In this case, each pixel region may include three data contact pads RCE1, GCE1, BCE1 applying the data voltage to the red, green, blue subminiature LEDs R1, G1, B1, respectively. Alternatively, each pixel region may further include a white LED in addition to the red, green, blue subminiature LEDs R1, R2, G1, G2, B1, B2. In this case, each pixel region may further include a data contact pad applying the data voltage to the white LED in addition to the data contact pads RCE1, GCE1, BCE1 applying the data voltage to the red, green, and blue subminiature LEDs R1, G1, B1, respectively. As a further alternative, each pixel region may only include at least one white LED without the red, green, and blue subminiature LEDs R1, G1, B1. In this case, each pixel region may further include red, green, and blue color filters corresponding in number to the white subminiature LEDs.

As described above, according to the present invention, when the base substrate ZPL is configured such that the area of the image display region or the size of the pixel regions is increased or reduced, it is not necessary to change layout of a plurality of subminiature LEDs R1, R2, G1, G2, B1, B2 to be mounted or deposited on each pixel region Pix. Here, a pixel region Pix at the center of the image display region has the plural subminiature LEDs R1, R2, G1, G2, B1, B2 at the center thereof, as shown in FIG. 3.

Referring to FIG. 3, the low voltage contact pad SE may be disposed at the center of the pixel region Pix and the plural subminiature LEDs R1, R2, G1, G2, B1, B2 may be disposed on a front side of the low voltage contact pad SE. Here, each of the subminiature LEDs R1, R2, G1, G2, B1, B2 emits light upon receiving, at the cathode thereof, the low voltage from the low voltage contact pad SE and upon receiving, at the anode thereof, the data voltage from the corresponding one of the data contact pads RCE1, GCE1, BCE1, RCE2, GCE2, BCE2 via the anode link line.

When the plural subminiature LEDs R1, R2, G1, G2, B1, B2 are disposed at the center of the pixel region Pix, the anode of each of the subminiature LEDs R1, R2, G1, G2, B1, B2 is connected to a contact hole C at one corner of each of the data contact pads RCE1, GCE1, BCE1, RCE2, GCE2, BCE2 via the anode link line to receive the data voltage.

Specifically, in a pixel region Pix adjacent to the center of the image display region, the contact hole C of each of the data contact pads RCE1, GCE1, BCE1, RCE2, GCE2, BCE2 is disposed closer to one corner of each data contact pad facing the center of the image display region. On the other hand, in a pixel region Pix adjacent to the periphery of the image display region, the contact hole C of each of the data contact pads RCE1, GCE1, BCE1, RCE2, GCE2, BCE2 is disposed closer to the other corner of the data contact pad diagonally away from the center of the image display region.

Accordingly, each of the subminiature LEDs R1, R2, G1, G2, B1, B2 disposed in a pixel region adjacent to the center of the image display region is connected to the contact hole C of each of the data contact pads RCE1, GCE1, BCE1, RCE2, GCE2, BCE2 adjacent to the one corner of the data contact pad via the anode link line to receive the data voltage. On the other hand, each of the subminiature LEDs R1, R2, G1, G2, B1, B2 disposed in a pixel region farther away from the center of the image display region is connected to the contact hole C of each of the data contact pads RCE1, GCE1, BCE1, RCE2, GCE2, BCE2 diagonally away from the one corner of the data contact pad via the anode link line to receive the data voltage.

In each pixel region Pix, the plural data contact pads RCE1, GCE1, BCE1, RCE2, GCE2, BCE2 correspond in number to the plural TFTs and the subminiature LEDs including the red, green, and blue subminiature LEDs R1, R2, G1, G2, B1, B2. Here, the data contact pads RCE1, GCE1, BCE1, RCE2, GCE2, BCE2 may be located in sections of the pixel region excluding the area occupied by the low voltage contact pad SE, respectively.

Although each of the data contact pads RCE1, GCE1, BCE1, RCE2, GCE2, BCE2 is shown as having a square shape in FIG. 3, it should be understood that the present invention is not limited thereto and each data contact pad may have a circular or polygonal shape in plan view. Here, the data contact pads RCE1, GCE1, BCE1, RCE2, GCE2, BCE2 may be located in sections of the pixel region excluding the area occupied by the low voltage contact pad SE, respectively, wherein the sections are equal in area and size.

Referring to FIG. 4, in the pixel region Pix adjacent to the center of the image display region, the contact hole C of each of the data contact pads RCE1, GCE1, BCE1, RCE2, GCE2, BCE2 is located adjacent to one corner of the data contact pad close to the center of the image display region. Thus, the contact hole C may be disposed close to the one corner of the data contact pad. Here, each of the data contact pads RCE1, GCE1, BCE1, RCE2, GCE2, BCE2 receives the data voltage from a corresponding one of the plurality of TFTs through a drain electrode and the contact hole and transmits the data voltage to a corresponding one of the red, green, and blue subminiature LEDs.

Particularly, each of the subminiature LEDs R1, G1, B1 receives, at the cathode thereof, the low voltage from the low voltage contact pad SE and receives, at the anode thereof, the data voltage from a corresponding one of the data contact pads RCE1, GCE1, BCE1, thereby emitting light at a brightness corresponding to the data voltage. Here, the cathode of each of the subminiature LEDs R1, G1, B1 is electrically connected to the low voltage contact pad SE via the common cathode link line. In addition, the anode of each of the subminiature LEDs R1, G1, B1 in electrically connected to a corresponding one of the data contact pads RCE1, GCE1, BCE1 via the anode link line.

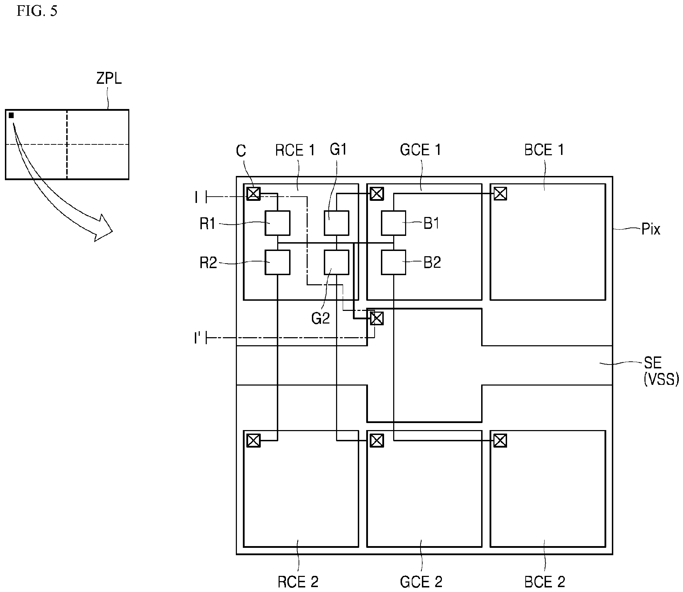

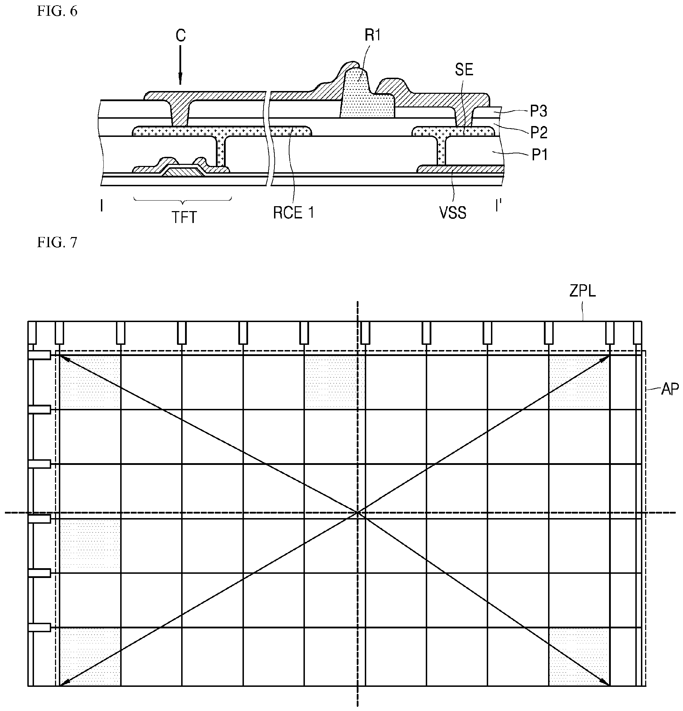

FIG. 5 is a block diagram of a pixel region adjacent to the outermost portion of the LED display panel of FIG. 1. FIG. 6 is a sectional view taken along line I-I' of FIG. 5.

Referring to FIGS. 5 and 6, when the base substrate ZPL is configured such that the area of the image display region or the size of the pixel regions is reduced or increased, it is not necessary to change the layout of the subminiature LEDs R1, R2, G1, G2, B1, B2 to be mounted or deposited in the pixel regions Pix. Accordingly, a pixel region Pix adjacent to the outer periphery of the image display region has the subminiature LEDs R1, R2, G1, G2, B1, B2 disposed at the outer periphery of the pixel region Pix, as shown in FIG. 5.

Specifically, depending on the degree of change in the area of the image display area or the size of the pixel regions, the location of a group of subminiature LEDs R1, R2, G1, G2, B1, B2 in a pixel region may change at a particular rate corresponding to the distance of the pixel region from the center of the image display region. For example, depending on the degree of increase or decrease in the area of the image display area or the size of the pixel regions, the location of the group of subminiature LEDs R1, R2, G1, G2, B1, B2 in the pixel region changes in a diagonal direction.

Accordingly, the pixel region Pix adjacent to the outermost portion of the image display region has a group of subminiature LEDs R1, R2, G1, G2, B1, B2 disposed adjacent to the outermost portion of the pixel region Pix, as shown in FIG. 5. Here, the group of subminiature LEDs R1, R2, G1, G2, B1, B2 may be disposed on a front side of at least one data contact pad RCE1, GCE1. Each of the subminiature LEDs R1, R2, G1, G2, B1, B2 emits light by receiving, at the cathode thereof, the low voltage from the low voltage contact pad SE and receiving, at the anode thereof, the data voltage from a corresponding one of the data contact pads RCE1, GCE1, BCE1, RCE2, GCE2, BCE2.

When the group of subminiature LEDs R1, R2, G1, G2, B1, B2 is disposed at a corner or edge of the pixel region Pix, the anode of each of the subminiature LEDs R1, R2, G1, G2, B1 B2 is connected to the contact hole C at the other corner of each data contact pad RCE1, GCE1, BCE1, RCE2, GCE2, BCE2 away from the center of the image display region via the anode link line to receive the data voltage.

In FIG. 4, since the pixel region Pix is adjacent to the center of the image display region, the contact hole C of each of the data contact pads RCE1, GCE1, BCE1, RCE2, GCE2, BCE2 is located adjacent to one corner of the data contact pad close to the center of the image display region. Accordingly, the contact hole C is disposed close to the one corner of each data contact pad. In FIG. 6, since the pixel region Pix is located far from the center of the image display region, the contact hole C of each of the data contact pads RCE1, GCE1, BCE1, RCE2, GCE2, BCE2 is located adjacent to the other corner of the data contact pad diagonally away from the center of the image display region. Accordingly, each of the subminiature LEDs R1, R2, G1, G2, B1, B2 disposed in the pixel region far from the center of the image display region is connected to the contact hole C diagonally away from one corner of each data contact pad RCE1, GCE1, BCE1, RCE2, GCE2, BCE2 close to the center of the image display region via the anode link line to receive the data voltage.

FIG. 7 is a diagram illustrating data voltage contact positions of a narrow- or zero-bezel type TFT switching substrate with subminiature LEDs arranged in a particular pattern thereon.

Referring to FIG. 7, when the base substrate ZPL is configured such that the overall size or area of the pixel regions is reduced due to the plurality of pads PD at the outer periphery of the substrate, the group of subminiature LEDs may be arranged with respect to the center of the base substrate ZPL without changing the layout of the subminiature LEDs, such that a pixel region farther away from the center of the image display region has the subminiature LEDs R1, R2, G1, G2, B1, B2 arranged in the same pattern as the pixel region close to the center of the image display region. In other words, subminiature LEDs R1, R2, G1, G2, B1, B2 in a pixel region at the center of the image display region and subminiature LEDs R1, R2, G1, G2, B1, B2 in the other pixel regions farther away from the center of the image display region may be arranged in the particular pattern in the direction away from the center of the image display region depending on the area of the image display region or the size of the pixel regions.

Here, a pixel region farther away from the center of the image display region has a group of the subminiature LEDs located closer to the outer periphery thereof. Particularly, the groups of subminiature LEDs disposed in the respective pixel regions of the base substrate ZPL may be equally spaced apart from one another in a direction away from the center of the image display region. Similarly, the contact hole C of each of the data contact pads RCE1, GCE1, BCE1, RCE2, GCE2, BCE2 is located closer to the other corner of the data contact pad diagonally away from the center of the image display region.

In addition, the distances between subminiature LEDs of adjacent groups in the direction away from the center of the image display region may vary depending on the area of the image display region or the size of the pixel regions. Here, depending on the degree of change in the area of the image display area or the size of the pixel regions, the location of a group of subminiature LEDs R1, R2, G1, G2, B1, B2 in a pixel region may change at a particular rate corresponding to the distance of the pixel region from the center of the image display region. Specifically, depending upon the degree of increase or decrease in the area of the image display region or the size of the pixel regions, the location of the group of subminiature LEDs R1, R2, G1, G2, B1, B2 in each pixel region may change in a diagonal direction.

As described above, the present invention provides an LED display panel which allows easy arrangement of subminiature LEDs in pixel regions of a TFT switching substrate for LCDs or OLED displays, thereby reducing design and production costs and improving automatic design efficiency, and a display using the same.

In addition, the present invention provides a narrow- or zero-bezel LED display panel which allows subminiature LEDs to be arranged in pixel regions without any additional design change in manufacture thereof, thereby reducing design and production costs, and a display using the same.

Further, the present invention provides an LED display panel which allows groups of subminiature LEDs to be respectively arranged in pixel regions in a particular pattern in a direction away from the center of the pixel regions, thereby improving ease of automatic design and panel inspection.

Although the present invention has been described with reference to some embodiments in conjunction with the accompanying drawings, it should be understood that the foregoing embodiments are provided for illustration only and are not to be in any way construed as limiting the present invention, and that various modifications, changes, and alterations, can be made by those skilled in the art without departing from the scope of the invention as defined by the claims.

### <List of Reference Numerals>

ZPL: base substrate
GL: gate line
DL: data line
Pix: pixel region
VDD: high voltage supply line
VSS: low voltage supply line
RCE1, GCE1, BCE1: data contact pad
SE: low voltage contact pad
R1, R2: red LED
G1, G2: green LED
B1, B2: blue LED

## Claims

1. An LED display panel comprising:
a base substrate (ZPL) having a plurality of pixel regions (Pix) defined by a plurality of gate lines (GL) and a plurality of data lines (DL) and comprising a plurality of pads (PD) arranged at an outer periphery of the base substrate (ZPL); and
a group of subminiature LEDs (R1, R2, G1, G2, B1, B2) disposed in each pixel region (Pix) to display an image,
wherein the subminiature LEDs (R1, R2, G1, G2, B1, B2) in each pixel region (Pix) are arranged in a particular pattern corresponding to a direction away from the center of the base substrate (ZPL) and in dependence on a distance of the pixel region (Pix) from the center of the base substrate (ZPL), and wherein the location of the pattern inside a pixel region (Pix) varies depending on the distance and direction of the pixel region to the center of the base substrate (ZPL).

2. The LED display panel according to claim 1, wherein a pixel region (Pix) farther away from the center of an image display region has the subminiature LEDs arranged in the same direction as a direction away from the center of the image display region and located closer to an outer periphery thereof depending on the area of the image display region or the size of the pixel regions.

3. The LED display panel according to claim 1 or 2, wherein the group of subminiature LEDs (R1, R2, G1, G2, B1, B2) in each pixel region (Pix) has the same pattern.

4. The LED display panel according to any one of the claims 1 to 3, wherein the group of subminiature LEDs (R1, R2, G1, G2, B1, B2) are disposed at the center of the pixel region (Pix) if the pixel region (Pix) is in the center of the base substrate (ZPL).

5. The LED display panel according to claim 4, wherein the group of subminiature LEDs (R1, R2, G1, G2, B1, B2) are shifted from the center of the pixel region (Pix) into a corner of the pixel region (Pix) the more the pixel region (Pix) is spaced apart from the center of the base substrate (ZPL), wherein the direction of shifting corresponds to the direction to the center of the base substrate (ZPL).

6. The LED display panel according to any one of the preceding claims, wherein each of the pixel regions (Pix) comprises:
a plurality of TFTs for switching a data voltage on a data line (DL) in response to gate-on voltage on a gate line (GL);
a low voltage contact pad (SE) to which low voltage is applied;
a plurality of data contact pads (RCE1, RCE2, GCE1, GCE2, BCE1, BCE2) being in one-to-one correspondence with the TFTs, the plurality of data contact pads (RCE1, RCE2, GCE1, GCE2, BCE1, BCE2) are configured to receive the data voltage from the TFTs of the corresponding subminiature LEDs (R1, R2, G1, G2, B1, B2).

7. The LED display panel according to claim 6, wherein in a pixel region (Pix) adjacent to the center of the base substrate (ZPL), a contact hole (C) of each of the data contact pads (RCE1, GCE1, BCE1, RCE2, GCE2, BCE2) is disposed closer to one corner of each data contact pad (RCE1, GCE1, BCE1, RCE2, GCE2, BCE2) facing the center of the base substrate (ZPL), wherein in a pixel region (Pix) adjacent to the periphery of the base substrate (ZPL), the contact hole (C) of each of the data contact pads (RCE1, GCE1, BCE1, RCE2, GCE2, BCE2) is disposed closer to a corner of the data contact pad (RCE1, GCE1, BCE1, RCE2, GCE2, BCE2) diagonally away from the center of the base substrate (ZPL), the contact hole (C) of each data contact pad (RCE1, GCE1, BCE1, RCE2, GCE2, BCE2) is configured to connect a corresponding anode of the subminiature LEDs (R1, R2, G1, G2, B1, B2).

8. The LED display panel according to claim 6 or 7, wherein the subminiature LEDs (R1, R2, G1, G2, B1, B2) comprise at least one red LED (R1, R2), at least one green LED (G1, G2), and at least one blue LED (B1, B2), wherein each of the subminiature LEDs (R1, R2, G1, G2, B1, B2) emitting light by receiving, at a cathode thereof, the low voltage from the low voltage contact pad (SE) and receiving, at an anode thereof, the data voltage from a corresponding one of the data contact pads (RCE1, RCE2, GCE1, GCE2, BCE1, BCE2).

9. The LED display panel according to claim 6, 7, or 8, wherein the plurality of data contact pads (RCE1, RCE2, GCE1, GCE2, BCE1, BCE2) corresponds in number to the TFTs and the subminiature LEDs (R1, R2, G1, G2, B1, B2).

10. The LED display panel according to any one of claims 6, 7, 8, or 9, wherein the plurality of data contact pads (RCE1, RCE2, GCE1, GCE2, BCE1, BCE2) is located in sections of the pixel region (Pix) excluding the area occupied by the low voltage contact pad (SE), respectively.

11. The LED display panel according to any one of claims 6, 7, 8, 9, or 10, wherein each of the plurality of data contact pads (RCE1, RCE2, GCE1, GCE2, BCE1, BCE2) at least in one pixel region (Pix) is equal in area and size.

12. The LED display panel according to any one of claims 6, 7, 8, 9, 10, or 11, wherein each of the data contact pads (RCE1, RCE2, GCE1, GCE2, BCE1, BCE2) is configured to receive the data voltage from a corresponding one of the plurality of TFTs and supplies the data voltage to a corresponding one of the red, green, and blue subminiature LEDs.

13. A display comprising:
an LED display panel as claimed in any one of the preceding claims, and
a driving circuit (100) configured to apply a high voltage and a low voltage to the pixel regions (Pix) and to drive gate lines (GL) and data lines (DL) of the LED display panel, such that an image is displayed by the subminiature LEDs (R1, R2, G1, G2, B1, B2) disposed in the pixel regions (Pix).

14. The display according to claim 13, wherein the driving circuit (100) is disposed on a back surface of the base substrate (ZPL) to apply the high voltage and the low voltage to the plurality of pixel regions (Pix) via a high voltage supply line (VDD) and a low voltage supply line (VSS) each extending from the back surface to a front surface of the base substrate (ZPL), respectively and to drive the gate lines (GL) and the data lines (DL) extending to the front surface of the base substrate (ZPL).

## Patentansprüche

1. LED-Anzeigetafel, die Folgendes umfasst:
ein Grundsubstrat (ZPL), das mehrere Pixelbereiche (Pix) aufweist, die durch mehrere Gate-Leitungen (GL) und mehrere Datenleitungen (DL) definiert sind, und mehrere Kontaktflächen (PD) umfasst, die an einem Außenumfang des Grundsubstrats (ZPL) angeordnet sind; und
eine Gruppe Kleinst-LED (R1, R2, G1, G2, B1, B2), die in jedem Pixelbereich (Pix) angeordnet sind, um ein Bild anzuzeigen,
wobei die Kleinst-LED (R1, R2, G1, G2, B1, B2) in jedem Pixelbereich (Pix) in einem bestimmten Muster entsprechend einer Richtung von der Mitte des Grundsubstrats (ZPL) weg und in Abhängigkeit von einem Abstand des Pixelbereichs (Pix) von der Mitte des Grundsubstrats (ZPL) angeordnet sind und wobei der Ort des Musters innerhalb eines Pixelbereichs (Pix) abhängig vom Abstand und von der Richtung des Pixelbereichs in Bezug auf die Mitte des Grundsubstrats (ZPL) variiert.

2. LED-Anzeigetafel nach Anspruch 1, wobei bei einem Pixelbereich (Pix), der von der Mitte eines Bildanzeigebereichs weiter entfernt ist, die Kleinst-LED in derselben Richtung wie eine Richtung von der Mitte des Bildanzeigebereichs weg angeordnet sind und abhängig von der Fläche des Bildanzeigebereichs oder der Größe der Pixelbereiche näher an seinem Außenumfang angeordnet sind.

3. LED-Anzeigetafel nach Anspruch 1 oder 2, wobei die Gruppe Kleinst-LED (R1, R2, G1, G2, B1, B2) in jedem Pixelbereich (Pix) dasselbe Muster aufweist.

4. LED-Anzeigetafel nach einem der Ansprüche 1 bis 3, wobei die Gruppe Kleinst-LED (R1, R2, G1, G2, B1, B2) in der Mitte des Pixelbereichs (Pix) angeordnet ist, wenn sich der Pixelbereich (Pix) in der Mitte des Grundsubstrats (ZPL) befindet.

5. LED-Anzeigetafel nach Anspruch 4, wobei die Gruppe Kleinst-LED (R1, R2, G1, G2, B1, B2) aus der Mitte des Pixelbereichs (Pix) in eine Ecke des Pixelbereichs (Pix) verschoben sind, je weiter der Pixelbereich (Pix) von der Mitte des Grundsubstrats (ZPL) beabstandet ist, wobei die Verschieberichtung der Richtung zur Mitte des Grundsubstrats (ZPL) entspricht.

6. LED-Anzeigetafel nach einem der vorhergehenden Ansprüche, wobei jeder der Pixelbereiche (Pix) Folgendes umfasst:
mehrere TFT zum Schalten einer Datenspannung auf eine Datenleitung (DL) als Antwort auf eine Gate-Ein-Spannung auf einer Gate-Leitung (GL);
eine Niederpotentialspannungs-Kontaktfläche (SE), an die eine Niederpotentialspannung angelegt wird;
mehrere Datenkontaktflächen (RCE1, RCE2, GCE1, GCE2, BCE1, BCE2), die in einer Eins-zu-Eins-Entsprechung zu den TFT stehen, wobei die mehreren Datenkontaktflächen (RCE1, RCE2, GCE1, GCE2, BCE1, BCE2) konfiguriert sind, die Datenspannung von den TFT der entsprechenden Kleinst-LED (R1, R2, G1, G2, B1, B2) zu empfangen.

7. LED-Anzeigetafel nach Anspruch 6, wobei in einem Pixelbereich (Pix), der zur Mitte des Grundsubstrats (ZPL) benachbart ist, ein Kontaktloch (C) von jeder der Datenkontaktflächen (RCE1, GCE1, BCE1, RCE2, GCE2, BCE2) näher an einer Ecke jeder Datenkontaktfläche (RCE1, GCE1, BCE1, RCE2, GCE2, BCE2), die der Mitte des Grundsubstrats (ZPL) zugewandt ist, angeordnet ist, wobei in einem Pixelbereich (Pix), der zum Außenumfang des Grundsubstrats (ZPL) benachbart ist, das Kontaktloch (C) von jeder der Datenkontaktflächen (RCE1, GCE1, BCE1, RCE2, GCE2, BCE2) näher an einer Ecke der Datenkontaktfläche (RCE1, GCE1, BCE1, RCE2, GCE2, BCE2), die von der Mitte des Grundsubstrats (ZPL) diagonal entfernt ist, angeordnet ist, wobei das Kontaktloch (C) jeder Datenkontaktfläche (RCE1, GCE1, BCE1, RCE2, GCE2, BCE2) konfiguriert ist, eine entsprechende Anode der Kleinst-LED (R1, R2, G1, G2, B1, B2) zu verbinden.

8. LED-Anzeigetafel nach Anspruch 6 oder 7, wobei die Kleinst-LED (R1, R2, G1, G2, B1, B2) mindestens eine rote LED (R1, R2), mindestens eine grüne LED (G1, G2) und mindestens eine blaue LED (B1, B2) umfassen, wobei jede der Kleinst-LED (R1, R2, G1, G2, B1, B2) Licht emittiert, indem sie an einer Kathode davon die Niederpotentialspannung von der Niederpotentialspannungs-Kontaktfläche (SE) empfängt und an einer Anode davon die Datenspannung von einer entsprechenden der Datenkontaktflächen (RCE1, RCE2, GCE1, GCE2, BCE1, BCE2) empfängt.

9. LED-Anzeigetafel nach Anspruch 6, 7 oder 8, wobei die Anzahl der mehreren Datenkontaktflächen (RCE1, RCE2, GCE1, GCE2, BCE1, BCE2) jener der TFT und der Kleinst-LED (R1, R2, G1, G2, B1, B2) entspricht.

10. LED-Anzeigetafel nach einem der Ansprüche 6, 7, 8 oder 9, wobei die mehreren Datenkontaktflächen (RCE1, RCE2, GCE1, GCE2, BCE1, BCE2) jeweils in Abschnitten des Pixelbereichs (Pix) mit Ausnahme der Fläche, die durch die Niederpotentialspannungs-Kontaktfläche (SE) belegt ist, angeordnet sind.

11. LED-Anzeigetafel nach einem der Ansprüche 6, 7, 8, 9 oder 10, wobei Fläche und Größe jeder der mehreren Datenkontaktflächen (RCE1, RCE2, GCE1, GCE2, BCE1, BCE2) zumindest in einem Pixelbereich (Pix) gleich sind.

12. LED-Anzeigetafel nach einem der Ansprüche 6, 7, 8, 9, 10 oder 11, wobei jede der Datenkontaktflächen (RCE1, RCE2, GCE1, GCE2, BCE1, BCE2) konfiguriert ist, die Datenspannung von einem entsprechenden der mehreren TFT zu empfangen, und die Datenspannung einer entsprechenden der roten, grünen und blauen Kleinst-LED zuführt.

13. Anzeige, die Folgendes umfasst:
eine LED-Anzeigetafel nach einem der vorhergehenden Ansprüche, und
eine Ansteuerschaltung (100), die konfiguriert ist, an die Pixelbereiche eine Hochpotentialspannung und eine Niederpotentialspannung anzulegen und die Gate-Leitungen (GL) und Datenleitungen (DL) der LED-Anzeigetafel anzusteuern, derart, dass durch die Kleinst-LED (R1, R2, G1, G2, B1, B2), die in den Pixelbereichen (Pix) angeordnet sind, ein Bild angezeigt wird.

14. Anzeige nach Anspruch 13, wobei die Ansteuerschaltung (100) auf einer Rückenfläche des Grundsubstrats (ZPL) angeordnet ist, um die Hochpotentialspannung und die Niederpotentialspannung über eine Hochpotentialspannungs-Versorgungsleitung (VDD) bzw. eine Niederpotentialspannungs-Versorgungsleitung (VSS), die sich jeweils von der Rückenfläche zu einer Stirnfläche des Grundsubstrats (ZPL) erstrecken, an die mehreren Pixelbereiche (Pix) anzulegen und die Gate-Leitungen (GL) und die Datenleitungen (DL), die sich zur Stirnfläche des Grundsubstrats (ZPL) erstrecken, anzusteuern.

## Revendications

1. Panneau d'affichage à LED comportant :
un substrat de base (ZPL) ayant une pluralité de régions de pixels (Pix) définies par une pluralité de lignes de grille (GL) et une pluralité de lignes de données (DL) et comportant une pluralité de plages (PD) agencées sur une périphérie extérieure du substrat de base (ZPL) ; et
un groupe de LED subminiatures (R1, R2, G1, G2, B1, B2) disposées dans chaque région de pixel (Pix) pour afficher une image,
dans lequel les LED subminiatures (R1, R2, G1, G2, B1, B2) dans chaque région de pixel (Pix) sont agencées selon un motif particulier correspondant à une direction s'éloignant du centre du substrat de base (ZPL) et en fonction d'une distance de la région de pixel (Pix) par rapport au centre du substrat de base (ZPL), et dans lequel l'emplacement du motif à l'intérieur d'une région de pixel (Pix) varie en fonction de la distance et de la direction de la région de pixel par rapport au centre du substrat de base (ZPL).

2. Panneau d'affichage à LED selon la revendication 1, dans lequel une région de pixel (Pix) plus éloignée du centre d'une région d'affichage d'image a les LED subminiatures agencées dans la même direction qu'une direction s'éloignant du centre de la région d'affichage d'image et située plus près d'une périphérie extérieure de celui-ci en fonction de la surface de la région d'affichage d'image ou de la taille des régions de pixels.

3. Panneau d'affichage à LED selon la revendication 1 ou 2, dans lequel le groupe de LED subminiatures (R1, R2, G1, G2, B1, B2) dans chaque région de pixel (Pix) a le même motif.

4. Panneau d'affichage à LED selon l'une quelconque des revendications 1 à 3, dans lequel les LED du groupe de LED subminiatures (R1, R2, G1, G2, B1, B2) sont disposées au centre de la région de pixel (Pix) si la région de pixel (Pix) est au centre du substrat de base (ZPL).

5. Panneau d'affichage à LED selon la revendication 4, dans lequel les LED du groupe de LED subminiatures (R1, R2, G1, G2, B1, B2) sont décalées du centre de la région de pixel (Pix) dans un coin de la région de pixel (Pix) où le plus de la région de pixel est espacé du centre du substrat de base (ZPL), dans lequel la direction de décalage correspond à la direction vers le centre du substrat de base (ZPL).

6. Panneau d'affichage à LED selon l'une quelconque des revendications précédentes, dans lequel chacune des régions de pixels (Pix) comporte :
une pluralité de TFT pour commuter une tension de données sur une ligne de données (DL) en réponse à une tension d'excitation de grille sur une ligne de grille (GL) ;
une plage de contact à tension faible (SE) à laquelle une tension faible est appliquée ;
une pluralité de plages de contact de données (RCE1, RCE2, GCE1, GCE2, BCE1, BCE2) étant en correspondance un à un avec les TFT, les plages de la pluralité de plages de contact de données (RCE1, RCE2, GCE1, GCE2, BCE1, BCE2) sont configurées pour recevoir la tension de données à partir des TFT des LED subminiatures (R1, R2, G1, G2, B1, B2) correspondantes.

7. Panneau d'affichage à LED selon la revendication 6, dans lequel dans une région de pixel (Pix) adjacente au centre du substrat de base (ZPL), un trou de contact (C) de chacune des plages de contact de données (RCE1, GCE1, BCE1, RCE2, GCE2, BCE2) est disposé plus près d'un coin de chaque plage de contact de données (RCE1, GCE1, BCE1, RCE2, GCE2, BCE2) faisant face au centre du substrat de base (ZPL), dans lequel dans une région de pixel (Pix) adjacente à la périphérie du substrat de base (ZPL), le trou de contact (C) de chacune des plages de contact de données (RCE1, GCE1, BCE1, RCE2, GCE2, BCE2) est disposé plus près d'un coin de la plage de contact de données (RCE1, GCE1, BCE1, RCE2, GCE2, BCE2) en s'éloignant diagonalement du centre du substrat de base (ZPL), le trou de contact (C) de chaque plage de contact de données (RCE1, GCE1, BCE1, RCE2, GCE2, BCE2) est configuré pour connecter une anode correspondante des LED subminiatures (R1, R2, G1, G2, B1, B2).

8. Panneau d'affichage à LED selon la revendication 6 ou 7, dans lequel les LED subminiatures (R1, R2, G1, G2, B1, B2) comportent au moins une LED rouge (R1, R2), au moins une LED verte (G1, G2) et au moins une LED bleue (B1, B2), dans lequel chacune des LED subminiatures (R1, R2, G1, G2, B1, B2) émet de la lumière en recevant, au niveau d'une cathode de celle-ci, la tension faible provenant de la plage de contact à tension faible (SE) et reçoit, au niveau d'une anode de celle-ci, la tension de données provenant d'une plage correspondante parmi les plages de contact de données (RCE1, RCE2, GCE1, GCE2, BCE1, BCE2).

9. Panneau d'affichage à LED selon la revendication 6, 7 ou 8, dans lequel la pluralité de plages de contact de données (RCE1, RCE2, GCE1, GCE2, BCE1, BCE2) correspond en nombre aux TFT et aux LED subminiatures (R1, R2, G1, G2, B1, B2).

10. Panneau d'affichage à LED selon l'une quelconque des revendications 6, 7, 8 ou 9, dans lequel la pluralité de plages de contact de données (RCE1, RCE2, GCE1, GCE2, BCE1, BCE2) est située dans des portions de la région de pixel (Pix) excluant la surface occupée par la plage de contact à tension faible (SE), respectivement.

11. Panneau d'affichage à LED selon l'une quelconque des revendications 6, 7, 8, 9 ou 10, dans lequel chaque plage de la pluralité de plages de contact de données (RCE1, RCE2, GCE1, GCE2, BCE1, BCE2) au moins dans une région de pixel (Pix) a une surface et une taille égales.

12. Panneau d'affichage à LED selon l'une quelconque des revendications 6, 7, 8, 9, 10 ou 11, dans lequel chacune des plages de contact de données (RCE1, RCE2, GCE1, GCE2, BCE1, BCE2) est configurée pour recevoir la tension de données provenant d'un TFT correspondant parmi la pluralité de TFT et délivre la tension de données à une LED correspondante parmi les LED subminiatures rouges, vertes et bleues.

13. Affichage comportant :
un dispositif d'affichage à LED selon l'une quelconque des revendications précédentes, et
un circuit de commande (100) configuré pour appliquer une tension élevée et une tension faible aux régions de pixels (Pix) et pour commander des lignes de grille (GL) et des lignes de données (DL) du panneau d'affichage à LED, de telle sorte qu'une image est affichée par les LED subminiatures (R1, R2, G1, G2, B1, B2) disposées dans les régions de pixels (Pix).

14. Affichage selon la revendication 13, dans lequel le circuit de commande (100) est disposé sur une surface arrière du substrat de base (ZPL) pour appliquer la tension élevée et la tension faible à la pluralité de régions de pixels (Pix) via une ligne d'alimentation en tension élevée (VDD) et une ligne d'alimentation en tension faible (VSS) s'étendant chacune à partir de la surface arrière jusqu'à une surface avant du substrat de base (ZPL), respectivement, et pour commander les lignes de grille (GL) et les lignes de données (DL) s'étendant jusqu'à la surface avant du substrat de base (ZPL).
